(19) Europäisches Patentamt
European Patent Office
Office européen des brevets

(11) **EP 2 409 615 B1**

(12) **EUROPÄISCHE PATENTSCHRIFT**

(45) Veröffentlichungstag und Bekanntmachung des Hinweises auf die Patenterteilung:
**24.06.2015 Patentblatt 2015/26**

(51) Int Cl.:
*A47J 41/00* *(2006.01)* *A47G 19/22* *(2006.01)*
*G01K 1/14* *(2006.01)* *H01L 35/28* *(2006.01)*
*A47J 45/06* *(2006.01)*

(21) Anmeldenummer: **10168738.2**

(22) Anmeldetag: **07.07.2010**

(54) **Behälter mit Anzeige**

Container with display

Récipient doté d'un affichage

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**25.01.2012 Patentblatt 2012/04**

(73) Patentinhaber:
• **Fraunhofer-Gesellschaft zur Förderung der Angewandten Forschung e.V.**
**80686 München (DE)**
• **Friedrich-Alexander-Universität Erlangen-Nürnberg**
**91054 Erlangen (DE)**

(72) Erfinder:
• **Pein, Sibylle**
**90419 Nürnberg (DE)**
• **Forster, Christian**
**90403 Nürnberg (DE)**

(74) Vertreter: **Stöckeler, Ferdinand Schoppe, Zimmermann, Stöckeler Zinkler, Schenk & Partner mbB Patentanwälte Radlkoferstrasse 2 81373 München (DE)**

(56) Entgegenhaltungen:
EP-A1- 2 225 978    EP-A1- 2 353 461
EP-A2- 1 884 179    CN-A- 101 352 307

EP 2 409 615 B1

**Beschreibung**

Ausführungsbeispiele der vorliegenden Erfindung betreffen einen Behälter mit einer selbstversorgenden Anzeigevorrichtung, insbesondere einen Behälter, der eine Anzeige und einen thermoelektrischen Generator zur Versorgung der Anzeige mit Energie aufweist.

Vorrichtungen, die thermische Energie in elektrische Energie umwandeln sowie Vorrichtungen, die elektrische Energie in thermische Energie umwandeln, werden in vielen Bereichen der Technik mit den unterschiedlichsten Zwecken eingesetzt. Ein thermoelektrischer Generator, der basierend auf dem Seebeck-Effekt, thermische Energie in elektrische Energie umwandelt, wird beispielsweise in http://www.reuters.com/article/idUS 129017+11-Mar-2008+BW20080311 beschrieben.

Ferner wird in der EP 197 291 0 A eine elektronische Detektionsvorrichtung für die Detektion einer Ausgangsleistung einer externen Einrichtung, z. B. der Ausgangsleistung eines Lichtemitters, beschrieben. Die Detektionsvorrichtung weist einen Detektor auf, der ausgebildet ist, eine von der Ausgangsleistung abhängige Variable zu detektieren, ferner weist die Detektionsvorrichtung eine Steuereinrichtung auf, die ausgebildet ist, ein Detektorsignal vom Detektor zu empfangen, wobei das Detektorsignal ein Anhaltspunkt für den nichtstationären Anfangswert der detektierten Variable ist. Die Steuereinrichtung ist ferner ausgebildet, das Detektorsignal zu verarbeiten und ein verarbeitetes Signal zu erzeugen. Eine Steuerung kombiniert das Detektorsignal und das verarbeitete Signal, um ein Signal auszugeben, das den stationären Wert der Variable angibt. Der Vorgang zur Bestimmung des stationären Wertes der Variable wird somit durch die Detektionsvorrichtung beschleunigt. In diesem Zusammenhang weist der Detektor einen Seebeck-Detektor auf, z. B. für die Detektion der Ausgangsleistung eines Lichtemitters.

Der dem Seebeck-Effekt entgegengesetzt gerichtete Peltier-Effekt wird in der JP 113 90 11 A angewandt, wobei eine Wasserflasche beschrieben wird, die zwei Gefäße aufweist, die über ein Peltier-Element miteinander verkoppelt sind. Um eine gute Warmhaltewirkung bzw. Kalthaltewirkung aufzuweisen, wird vom Peltier-Element die Temperatur des warm zu haltenden Gefäßes angehoben, während die Temperatur des kalt zu haltenden Gefäßes abgesenkt wird. Wenn die Temperatur der heizenden Seite des Peltier-Elements höher ist als die Wassertemperatur des warm zu haltenden Gefäßes, dann fließt eine Wärmeenergie von der heizenden Seite des Peltier-Elements über einen ersten Wärmeleiter in das warm zu haltenden Gefäß, dabei wird die Wärme in das Wasser geleitet und das Wasser somit aufgeheizt. Wenn die Temperatur der kühlenden Seite des Peltier-Elements niedriger ist, als die Wassertemperatur im kalt zu haltenden Gefäß, dann fließt die Wärmeenergie des Wassers im kalt zu haltenden Gefäß über einen zweiten Wärmeleiter aus dem kalt zu haltenden Gefäß heraus und wird von der kühlenden Seite des Peltier-Elements aufgenommen, wodurch das Wasser im kalt zu haltenden Gefäß gekühlt wird. Ferner werden die Temperaturen des heißen und kalten Wassers über eine Temperaturanzeige angezeigt.

Ferner ist ein kommerziell verfügbarer und thermisch isolierter Becher mit einer LCD-Anzeigevorrichtung (LCD = Liquid Crystal Display, dt. Flüssigkristallanzeige) bekannt. Auf der Außenseite des thermisch isolierten Bechers ist eine Befestigungsvorrichtung angeordnet, die eine LCD-Anzeigevorrichtung über eine lösbare mechanische Verbindung aufnehmen kann. Die LCD-Anzeigevorrichtung weist eine 1,5 Zoll große LCD-Anzeige auf, die ausgebildet ist, um Bilder aus einem internen Speicher anzuzeigen. Für die Übertragung neuer Bilder auf den internen Speicher wird die LCD-Anzeigevorrichtung vorzugsweise aus der Befestigungseinrichtung entnommen und über eine kabelgebundene USB-Schnittstelle z. B. mit einem PC verbunden. Auf dem internen Speicher der LCD-Anzeigevorrichtung können anschließend bis zu 45 Bilder übertragen und gespeichert werden. Nach der Trennung der kabelgebundenen USB-Verbindung, wird die LCD-Anzeigevorrichtung über einen internen Energiespeicher, z. B. über eine Nickel-Metall-Hydrid-Akkumulator, mit Energie versorgt.

Die LCD-Anzeige des kommerziell verfügbaren Bechers erfordert jedoch eine kontinuierliche Versorgung mit Energie im eingeschalteten Zustand und somit während der Anzeige von Bildern. Wenn der Energiespeicher der LCD-Anzeigevorrichtung erschöpft ist, muss dieser erneut geladen werden, z. B. über die USB-Schnittstelle. Ferner ist es jedes Mal erforderlich, die LCD-Anzeigevorrichtung über die USB-Schnittstelle mit z. B. einem PC zu verbinden, um neue bzw. andere Bilder auf den internen Speicher zu übertragen. Des Weiteren ist die LCD-Anzeigevorrichtung nicht in der Lage, z. B. Kurznachrichten oder Meldungen zu empfangen und anzuzeigen. Darüber hinaus ist die LCD-Anzeigevorrichtung nicht Bestandteil der Außenseite des Bechers, wodurch der Becher in der Handhabung beeinträchtigt ist. Ferner ist es erforderlich, die LCD-Anzeigevorrichtung aus der Befestigungseinrichtung zu entnehmen, um eine hygienische Reinigung der Befestigungseinrichtung während eines Waschvorgangs des Bechers, z. B. in der Spülmaschine, sicher zu stellen.

Der vorliegenden Erfindung liegt die Aufgabe zugrunde, einen Behälter zu schaffen, der eine Anzeigevorrichtung aufweist, die ausgebildet ist, sich selbst mit Energie zu versorgen. Ein ählicher Behälter ist aus der CN 101 352 307 A bekannt.

Diese Aufgabe wird durch einen Behälter gemäß Anspruch 1 gelöst.

Die Erfindung schafft somit einen Behälter mit einer Anzeige und einem thermoelektrischen Generator zur Versorgung der Anzeige mit elektrischer Energie. Der thermoelektrische Generator kann dabei, z. B. basierend auf dem Seebeck-Effekt, die durch einen im Behälter befindlichen Stoff hervorgerufene Temperaturdifferenz zwischen Behälterinnenseite und Behälteraußenseite nutzen, um die für die Anzeige erforderliche elektrische Energie zu erzeugen.

Bei Ausführungsbeispielen der Erfindung ist auf der Außenseite des Behälters eine Anzeige aufgebracht, um Daten, wie z. B. Informationen, kurze Nachrichten, Meldungen, Bilder, Fotos und/oder Grafiken, anzuzeigen. Ferner ist bei Ausführungsbeispielen der Erfindung im Bereich des Behälterbodens ein thermoelektrischer Generator angeordnet, der z. B. basierend auf dem Seebeck-Effekt, bei einer Temperaturdifferenz zwischen Behälterinnenseite und Behälteraußenseite, eine von der Temperaturdifferenz abhängige elektrische Energie erzeugt. Die erzeugte elektrische Energie kann genutzt werden, um die Anzeige, z. B. ein elektronisches Papier, mit Energie zu versorgen. Bei Ausführungsbeispielen der Erfindung kann somit z. B. die Wärmeenergie eines im Behälter befindlichen Heißgetränks genutzt werden, um mit Hilfe des thermoelektrischen Generators die Anzeige mit elektrischer Energie zu versorgen.

Ausführungsbeispiele der vorliegenden Erfindung werden nachfolgend unter Bezugnahme auf die beiliegenden Zeichnungen näher erläutert. Es zeigen:

Fig. 1    eine schematische Schnittansicht eines Behälters,

Fig. 2    eine schematische Schnittansicht eines Behälters, wobei der Behälter im Bereich des Behälterbodens ferner ein Energiespeicher und eine Verarbeitungseinrichtung aufweist,

Fig. 3    eine schematische Schnittansicht eines Ausführungsbeispiels eines erfindungsgemäßen Behälters mit einer E-Paper-Anzeige, einem thermoelektrischen Generator und einem Funksystem, z. B. für den drahtlosen Empfang anzuzeigender Informationen,

Fig. 4    eine schematische Schnittansicht eines Ausführungsbeispiels eines erfindungsgemäßen Behälters, der im Bereich des Behälterbodens ferner ein NFC-Modul aufweist.

In der nachfolgenden Beschreibung der Ausführungsbeispiele der Erfindung werden in den Figuren gleiche oder gleich wirkende Elemente mit den gleichen Bezugszeichen versehen.

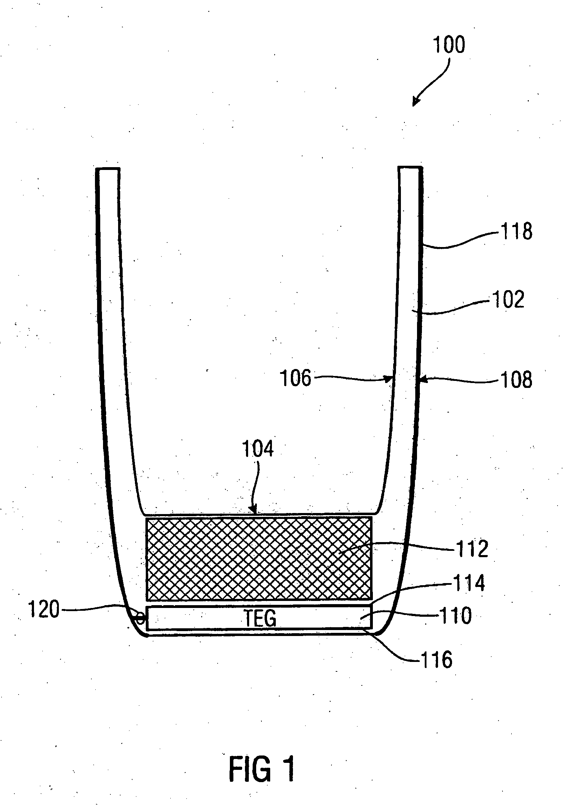

Fig. 1 zeigt eine schematische Schnittansicht eines Behälters 100. Der Behälter 100 weist eine Behälterwand 102 auf. Die Behälterwand 102 kann z. B. nach unten hin zusammenlaufen, um einen Behälterboden 104 zu bilden. Die Behälterwand 102 kann ferner z. B. ein thermisch isolierendes Material oder eine thermisch isolierende Schicht aufweisen, um z. B. ein im Behälter befindliches Heißgetränk von der Umgebung des Behälters thermisch zu isolieren. Ferner ist der Behälter 100 durch eine Behälterinnenseite 106 und eine Behälteraußenseite 108 gekennzeichnet. In dem in Fig. 1 gezeigten Ausführungsbeispiel ist der thermoelektrische Generator 110 im unteren Bereich des Behälterbodens 104 angeordnet. Ferner weist der Behälterboden 104 ein thermisch leitfähiges Material bzw. eine thermisch leitfähige Schicht 112 auf, die im oberen Bereich des Behälterbodens 104 oberhalb des thermoelektrischen Generators 110 angeordnet ist, um eine gute Wärmeübertragung zwischen der Behälterinnenseite 106 und somit z. B. zwischen einem im Behälter befindlichen Heißgetränk und der oberen Seite 114 des thermoelektrischen Generators 110 zu gewährleisten. Eine gute Wärmeübertragung zwischen der unteren Seite 116 des thermoelektrischen Generators 110 und der Behälteraußenseite 108, wird gemäß dem in Fig. 1 gezeigten Ausführungsbeispiel bedingt durch die Anordnung des thermoelektrischen Generators 110 im unteren Bereich des Behälterbodens 104, benachbart zur Behälteraußenseite 108, gewährleistet. Bei einer Temperaturdifferenz zwischen Behälterinnenseite 106 und Behälteraußenseite 108 erzeugt der thermoelektrische Generator 110 somit, z. B. basierend auf dem Seeback-Effekt, eine von der Temperaturdifferenz abhängige elektrische Energie. Eine Anzeige 118, z. B. ein elektronisches Papier (E-Paper), ist in dem in Fig. 1 gezeigten Beispiel auf der Behälteraußenseite 108 aufgebracht. Dabei kann die Anzeige 118 z. B. die Behälteraußenseite 108 ganz oder teilweise abdecken. Ferner kann die Anzeige 118 derart auf der Behälteraußenseite 108 aufgebracht sein, dass z. B. optisch und / oder haptisch keine Übergänge zwischen Behälteraußenseite 108 und Anzeige 118 erkennbar sind. Über eine Schnittstelle 120, z. B. über eine zweipolige elektrische Verbindung, kann die Anzeige 118 mit der vom thermoelektrischen Generator 110 erzeugten elektrischen Energie versorgt werden. Der Behälter 100 ist somit in der Lage, die für die Anzeige 118 erforderliche Energie selbst zu erzeugen. Auf einen internen Energiespeicher, der über eine externe Energiequelle aufgeladen werden muss, kann somit verzichtet werden.

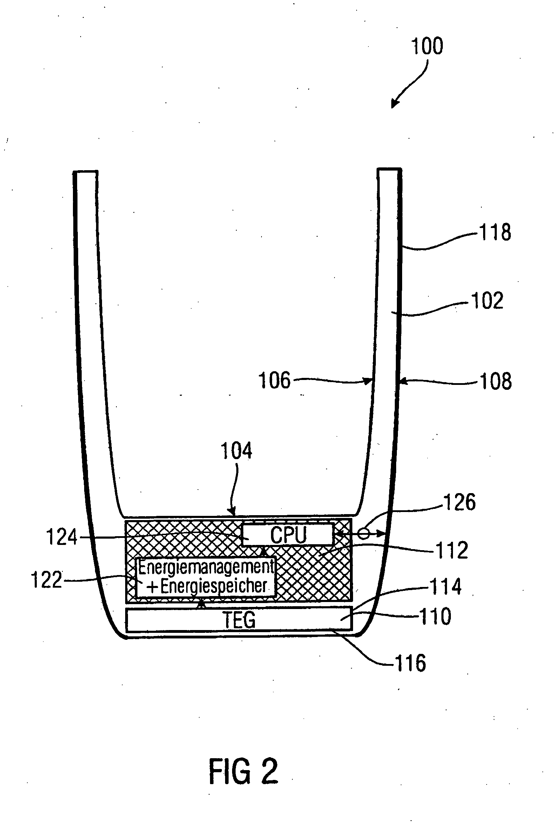

Fig. 2 zeigt eine schematische Schnittansicht eines Ausführungsbeispiels des erfindungsgemäßen Behälters 100, wobei der Behälter 100 im Bereich des Behälterbodens 104 ferner einen Energiespeicher 122 und eine Verarbeitungseinrichtung 124 aufweist. Der Energiespeicher 122 kann z. B. einen Kondensator aufweisen, um die vom thermoelektrischen Generator 110 erzeugte elektrische Energie zu speichern. Ferner kann der Energiespeicher 122 z. B. eine elektronische Schaltung aufweisen, die ausgebildet ist, um Energiemanagementfunktionen bzw. Energieverwaltungsfunktionen zu übernehmen, um z. B. zu entscheiden, wann die gespeicherte Energie abgegeben wird. Die über den thermoelektrischen Generator 110 erzeugte Energie wird somit in dem Energiespeicher 122 zwischengespeichert, so dass diese über einen kurzen Zeitraum von einigen Sekunden konzentriert entnommen werden kann. Dies ist vorteilhaft, wenn die Anzeige 118 keinen dauerhaften Stromfluss benötigt, sondern ausschließlich bei einer Umprogrammierung mit Energie versorgt werden muss. Derartige Anzeigen sind z. B. als elektronisches Papier (E-Paper) bekannt. Für die Umprogrammierung der Anzeige 118 kann ferner eine Verarbeitungseinrichtung 124 zum Einsatz kommen, die ausgebildet ist, um z. B. die logischen Vorgänge zu koordinieren. Die Verarbeitungseinrichtung 124 kann dabei z. B. die üblichen Komponenten für ein eingebettetes System aufweisen. Die Verarbeitungseinrichtung 124 ist ferner über eine Schnittstelle 126 mit der Anzeige 118 verbunden. Ferner kann die Verarbeitungseinrichtung 124 einen Datenspeicher aufweisen, der ausgebildet ist, um Daten wie z. B. Informationen, Meldungen, Kurznachrichten, Bilder, Fotos und/oder Grafiken zu speichern, die nach der Umprogrammierung der Anzeige angezeigt werden können.

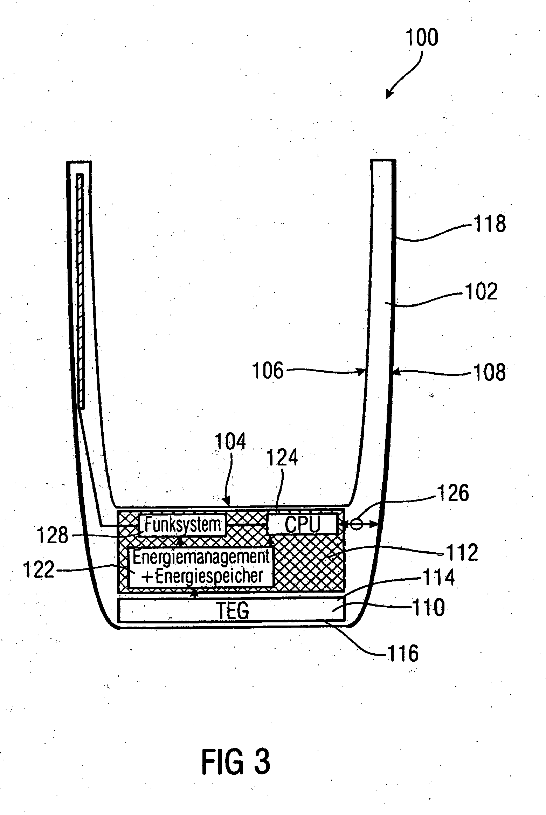

Fig. 3 zeigt eine schematische Schnittansicht eines Ausführungsbeispiels eines erfindungsgemäßen Behälters 100 mit einer E-Paper-Anzeige 118 und einem Funksystem 128, z. B. für den drahtlosen Empfang anzuzeigender Informationen. Der thermoelektrische Generator 110 fungiert dabei als Energiequelle der E-Paper-Anzeige 118, der Verarbeitungseinrichtung 124 und des Funksystems 128. Ferner ist der Energiespeicher 122, die Verarbeitungseinrichtung 124 und das Funksystem 128 in ein thermisch leitfähiges Material 112 derart eingebettet, dass deren Abwärme zu der Energiebilanz des thermoelektrischen Generators 110 beitragen kann. Da die E-Paper-Anzeige 118, die Verarbeitungseinrichtung 124 und das Funksystem 128 nur wenige Sekunden während des Vorgangs der Umprogrammierung der E-Paper-Anzeige 118 aktiv sind, wird der durchschnittliche Energieverbrauch folgendermaßen geschätzt:

| Funksystem 128 | 100 mW |
|---|---|
| Verarbeitungseinrichtung 124 | 100 mW |
| E-Paper-Anzeige 118 während der Umprogrammierung | 100 mW |

Darüber hinaus wird der Wirkungsgrad des Energiespeichers 122, der eine elektronische Schaltung zur Energieverwaltung aufweist, mit 0,8 angenommen. Handelsübliche thermoelektrische Generatoren erreichen einen Wirkungsgrad von ca. 0,1. Daraus ergibt sich eine geschätzte Brutto-Leistungsaufnahme von 375 mW. Wird z. B. eine wasserähnliche Flüssigkeit mit einem Volumen von 250 ml und einer Dauer von 10 Sekunden für den Vorgang der Umprogrammierung der E-Paper-Anzeige 118 angenommen, so sinkt die Temperatur der Flüssigkeit um:

$$\Delta T = \frac{375 mW \cdot 10s}{0,1 \cdot 0,250 kg \cdot 4,2 \frac{kJ}{kg \cdot K}} = 0,036K$$

Bei der Verwendung einer Technologie, wie beispielsweise in http://www.reuters.com/article/idUS129017+11Mar-2008+BW20080311 beschrieben und einer Temperaturdifferenz von Behälterinnenseite 106 zu Behälteraußenseite 108 von ca. 20 K, würde die benötigte Energiemenge nach ca. 4 Minuten bereitstehen.

Ferner weist das in Fig. 3 gezeigte Ausführungsbeispiel eines erfindungsgemäßen Behälters 100 im Bereich des Behälterbodens 104 ein Funksystem 128 sowie im Bereich der Behälterwand 102 eine Antenne 130 auf. Der Behälter 100 kann grundsätzlich ein beliebiges kompaktes Funksystem aufweisen, wobei in der Regel ein digitales Funksystem bevorzugt wird. Das Funksystem 128 kann z. B. ausgebildet sein, um die anzuzeigenden Daten über WLAN (Wireless Local Area Network, dt. Drahtloses lokales Netzwerk) nach dem IEEE 802.11 Standard zu empfangen. Die Verwendung eines WLAN basierten Funksystems 128 erfordert die Anmeldung an einem Access-Point (dt. Zugangspunkt). Die hierzu benötigten Informationen können z. B. durch den Hersteller vorkonfiguriert werden. Ferner kann für die Konfiguration des Funksystems 118 eine Konfigurationssoftware und eine WLAN Ad-Hoc-Verbindung (dt. eine drahtlose lokale Netzwerkverbindung zwischen zwei Endgeräten, die ohne feste Infrastruktur auskommen) verwendet werden. Ferner kann zum Beitreten zu einem WLAN Netzwerk oder für die Herstellung einer WLAN Verbindung ein Wi-Fi Protected Setup (WPS, dt. ein von der Wi-Fi Alliance entwickelter Standard zum einfachen und sicheren Aufbau eines drahtlosen Netzwerks) verwendet werden. Ferner kann das Funksystem 128 ausgebildet sein, um die anzuzeigenden Daten über eine Mobilfunkverbindung, wie z. B. über GSM (Global System for Mobile Communications, dt. Globales System für Mobilkommunikation) oder über UMTS (Universal Mobile Telecommunications System, dt. Universelles mobiles Telekommunikationssystem) zu empfangen. Des Weiteren kann das Funksystem ausgebildet sein, um die anzuzeigenden Daten über ein Rundfunksystem wie z. B. über DVB-T (Digital Video Broadcast - Terrestrial, dt. Digitaler erdgebundener Videorundfunk) oder über DVB-SH (Digital Video Broadcast - Satellite Services to Handheld Devices, dt. Digitaler Videorundfunk über Satellit für Handgeräte) zu empfangen. DVB-Systeme sind europaweit verfügbar und erlauben, z. B. bei der Verwendung von DVB-T, eine gute Innenraumversorgung. Falls das Funksystem 128 noch keine Informationen über die verwendeten Rundfunk- bzw. Netzwerkdaten besitzt, werden diese zunächst, z. B. über einen Frequenzsuchlauf, ermittelt. Anschließend kann das Funksystem 128 die anzuzeigenden Daten des festgelegten Rundfunkdienstes empfangen und dekodieren. Die Verwendung eines Rundfunksystems erfordert jedoch die Ausstrahlung der anzuzeigenden Daten durch den festgelegten Rundfunkdienst.

In dem in Fig. 3 gezeigten Ausführungsbeispiel, kann die E-Paper-Anzeige 118 z. B. die Behälteraußenseite 108 ganz oder teilweise abdecken. Nachdem vom Funksystem 128 neue Daten empfangen wurden, kann die E-Paper-Anzeige 118 über die Verarbeitungseinrichtung 124 mit diesen aktualisiert werden. Da die E-Paper-Anzeige 118 keinen dauerhaften Stromfluss benötigt, wird diese ausschließlich bei der Umprogrammierung mit Energie versorgt. Die Verarbeitungseinrichtung 124 steuert den Vorgang der Umprogrammierung und kann dabei z. B. die üblichen Komponenten für ein eingebettetes System aufweisen.

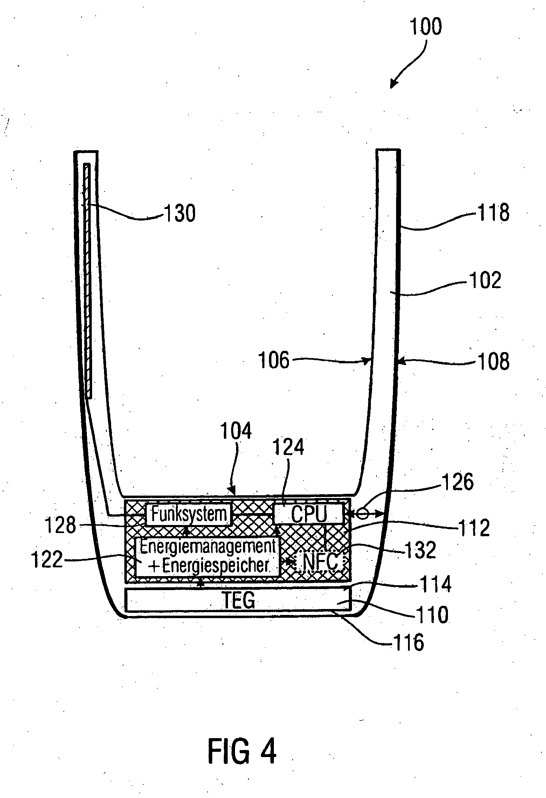

Fig. 4 zeigt eine schematische Ansicht eines Ausführungsbeispiels eines erfindungsgemäßen Behälters 100, der im Bereich des Behälterbodens 104 ferner ein NFC-Modul (NFC = Near-Field-Communication, dt. Nahfeldkommunikation) 132 aufweist. Das NFC-Modul 132 ermöglicht die Konfiguration des Funksystems 128, wobei die während der Konfiguration benötigte Energie über das NFC-Modul 132 bereitgestellt wird. Nachdem z. B. die erforderlichen Informationen für die Anmeldung an einem WLAN Access-Point übertragen wurden, kann das Funksystem 128 die anzuzeigenden Daten von z. B. einer vorkonfigurierten Kommunikationsadresse, z. B. aus dem Internet, herunterladen. Ferner ist das NFC-Modul 132 derart in das thermisch leitfähige Material 112 eingebettet, dass dessen Abwärme ebenfalls zu der Energiebilanz des thermoelektrischen Generators 110 beitragen kann.

Die Erfindung beschreibt einen Behälter mit einer Anzeige zum Anzeigen von Daten, wie z. B. Informationen, kurze Nachrichten, Meldungen, Bilder, Fotos und/oder Grafiken. Der Behälter weist dabei folgende Komponenten auf: Einen thermoelektrischen Generator, der z. B. basierend auf dem Seebeck-Effekt als Energiequelle fungiert, sobald z. B. eine heiße Flüssigkeit in den Behälter gefüllt wird. Der thermoelektrische Generator kann dabei als Teil der Behälterwand ausgeführt sein und z. B. im Bereich des Behälterbodens angeordnet sein. Die über den thermoelektrischen Generator erzeugte Energie kann in einem Energiespeicher, wie z. B. in einem Kondensator, zwischengespeichert werden, so dass diese über einen kurzen Zeitraum von einigen Sekunden konzentriert entnommen werden kann. Ferner weist der Behälter ein Funksystem und eine Antenne zum Empfangen anzuzeigender Daten auf, wobei das Funksystem im Bereich des Behälterbodens und die Antenne im Bereich der Behälterwand angeordnet sein kann. Ferner kann der Behälter eine Anzeige aufweisen, die z. B. die Behälteraußenseite ganz oder teilweise abdeckt, wobei die Anzeige z. B. ein elektronisches Papier aufweisen kann. Des Weiteren kann der Behälter eine Verarbeitungseinrichtung aufweisen, die z. B. einen Mikroprozessor umfasst der ausgebildet ist, um die logischen Vorgänge zu koordinieren. Ferner kann der Behälter ein NFC-Modul, z. B. zur Konfiguration des Funksystems, aufweisen.

Bei Ausführungsbeispielen der Erfindung kann der Behälter, z. B. auf der Behälteraußenseite ein Push Button Interface (dt. Schnittstelle mit einem Eingabetaster) aufweisen, um Aktionen manuell auslösen zu können, wie z. B. dem Start einer WLAN-Suche oder einer Aktualisierung. Das Push Button Interface kann dabei z. B. als Folientaster oder magnetischer Taster z. B. als Reed Kontakt ausgeführt sein. Alternativ zu einem Eingabetaster kann der Behälter, z. B. im Bereich des Behälterbodens einen Bewegungssensor aufweisen, der ausgebildet ist, um bei der Erfassung einer Bewegung die gewünschte Aktion auszulösen.

Ausführungsbeispiele der Erfindung wurden beschrieben, in denen der thermoelektrische Generator 110 im unteren Bereich des Behälterbodens 104 angeordnet ist. Die Erfindung ist jedoch nicht auf solche Ausführungsbeispiele beschränkt, sondern vielmehr kann der thermoelektrische Generator 110 in einem beliebigen Bereich zwischen Behälterinnenseite 106 und Behälteraußenseite 108, z. B. innerhalb der Behälterwand 102 oder im mittleren oder im oberen Bereich des Behälterbodens 104, derart angeordnet sein, dass der thermoelektrische Generator 110 bei einer Temperaturdifferenz zwischen Behälterinnenseite 106 und Behälteraußenseite 108 eine von der Temperaturdifferenz abhängige elektrische Energie erzeugt. Ferner kann die Wärmeübertragung von Behälterinnenseite 106 und Behälteraußenseite 108 zu beiden Seiten 114 und 116 des thermoelektrischen Generators 110 durch ein entsprechend angeordnetes thermisch leitfähiges Material bzw. durch eine thermisch leitfähige Schicht 112 verbessert werden.

Ferner wurden Ausführungsbeispiele der Erfindung beschrieben, in denen der thermoelektrische Generator 110 zur Erzeugung elektrischer Energie die im Behälter 100 befindliche Wärmeenergie eines Heißgetränks nutzt. Die Erfindung ist jedoch nicht auf solche Ausführungsbeispiele beschränkt, sondern vielmehr ist der thermoelektrische Generator 110 ausgebildet, bei einer Temperaturdifferenz zwischen Behälterinnenseite 106 und Behälteraußenseite 108 eine von der Temperaturdifferenz abhängige elektrische Energie zu erzeugen. Eine Temperaturdifferenz zwischen Behälterinnenseite 106 und Behälteraußenseite 108 kann ein beliebiger im Behälter befindlicher Stoff, z. B. flüssiger oder fester Form, hervorrufen, dessen Temperatur oberhalb oder unterhalb der Umgebungstemperatur des Behälters 100 und somit oberhalb oder unterhalb der Temperatur der Behälteraußenseite 108 liegt, z. B. eine Temperaturdifferenz hervorgerufen durch ein im Behälter befindliches Eis oder Kaltgetränk bei einer entsprechend hohen Außentemperatur. Die Anordnung des Energiespeichers 122, der Verarbeitungseinrichtung 124, des Funksystems 128 oder des NFC-Moduls 132 ist dabei so gewählt werden, dass deren Abwärme zu der Energiebilanz des thermoelektrischen Generators 110 beiträgt, z. B. durch deren Anordnung im Bereich zwischen Behälterinnenseite 106 und oberen Seite 114 des thermoelektrischen Generators 110 bei einem Behälter 100 für Heißgetränke und z. B. durch deren Anordnung im Bereich zwischen Behälteraußenseite 108 und unteren Seite 116 des thermoelektrischen Generators 110 bei einen Behälter 100 für Kaltgetränke.

Des Weiteren wurden Ausführungsbeispiele der Erfindung beschrieben, bei denen die Anzeige 118 ein elektronisches Papier aufweist. Die Erfindung ist jedoch nicht auf solche Ausführungsbeispiele beschränkt, sondern vielmehr kann die Anzeige 118 eine elektronische oder eine mechanische Anzeige oder eine Kombination aus beiden aufweisen, die lediglich Energie bei der Umprogrammierung bzw. beim Wechsel der angezeigten Daten, z. B. Informationen, kurze Nachrichten, Meldungen, Bilder, Fotos und/oder Grafiken erfordert. Im Bereich der Mechanik sind z. B. bistabile Anzeigeelemente, die in einer Matrix angeordnet werden oder Faltblattanzeigen bekannt. Ferner wäre es in Zukunft denkbar, bei einem steigendem Wirkungsgrad des thermoelektrischen Generators 110 eine bistabile LCD-Anzeige, mit z. B. einer OLED (Organic Light Emitting Diode, dt. organische lichtemittierende Diode) Hintergrundbeleuchtung oder einer noch energiesparsameren Technik einzusetzen.

Ferner wurden Ausführungsbeispiele der Erfindung beschrieben, bei denen die Anzeige 118 auf der Behälteraußenseite 108 aufgebracht ist. Die Erfindung ist aber nicht auf solche Ausführungsbeispiele beschränkt, sondern vielmehr kann die Anzeige 118 ebenfalls auf der Behälterinnenseite 106 und auf dem Behälterboden 104 aufgebracht sein.

## Patentansprüche

1. Behälter für ein Getränk, mit folgenden Merkmalen:

   einem thermoelektrischen Generator (110), der ausgebildet ist, um bei einer Temperaturdifferenz zwischen Behälterinnenseite (106) und Behälteraußenseite (108) eine von der Temperaturdifferenz abhängige elektrische Energie zu erzeugen;
   einer Anzeige (118), die auf der Behälterinnenseite (106) und/oder der Behälteraußenseite (108) aufgebracht ist und ausgebildet ist, um von der Energie des thermoelektrischen Generators (110) versorgt zu werden; und
   einem Funksystem (128) und einer Antenne (130) zum Empfangen der anzuzeigenden Daten, wobei das Funksystem (128) ausgebildet ist, um von der Energie des thermoelektrischen Generators (110) versorgt zu werden;
   wobei die Anzeige (118) ausgebildet ist, um die empfangenen anzuzeigenden Daten anzuzeigen;
   wobei der thermoelektrische Generator (110) im Bereich zwischen Behälterinnenseite (106) und Behälteraußenseite (108) angeordnet ist;
   wobei die Behälterwand (102) im Bereich des thermoelektrischen Generators (110) ein thermisch leitfähiges Material (112) aufweist, um die Wärmeübertragung zwischen Behälterinnenseite (106) und thermoelektrischem Generator (110) und / oder Behälteraußenseite (108) und thermoelektrischem Generator (110) zu erhöhen; und
   wobei ein Energiespeicher (122), eine Verarbeitungseinrichtung (124), das Funksystem (128) und/oder ein NFC-Modul im Bereich des thermisch leitfähigen Materials (112) derart angeordnet sind, dass deren generierte Abwärme, zumindest zum Teil, erneut vom thermoelektrischen Generator (110) zur Energiegewinnung genutzt wird.

2. Behälter (100) nach Anspruch 1, bei dem der thermoelektrische Generator (110) ausgebildet ist, um die elektrische Energie durch den Seebeck-Effekt zu erzeugen.

3. Behälter (100) nach Anspruch 1 oder 2, bei dem die Anzeige (118) eine elektrische Anzeige oder mechanische Anzeige oder eine Kombination aus beidem umfasst.

4. Behälter (100) nach Anspruch 1, bei dem die Anzeige (118) ausgebildet ist, um nur bei einem Wechsel der anzuzeigenden Daten Energie zu verbrauchen, wobei die Anzeige (118) ein elektronisches Papier, ein bistabiles Anzeigeelement, eine Faltblattanzeige oder eine bistabile LCD-Anzeige umfasst.

5. Behälter (100) nach einem der Ansprüche 1 bis 4, mit einem Energiespeicher (122), der ausgebildet ist, um die erzeugte Energie des thermoelektrischen Generators (110) zu speichern.

6. Behälter (100) nach Anspruch 5, bei dem der Energiespeicher (122) eine elektronische Schaltung umfasst, die ausgebildet ist, um Energieverwaltungsfunktionen auszuführen.

7. Behälter (100) nach einem der Ansprüche 1 bis 6, mit einer Verarbeitungseinrichtung (124), die ausgebildet ist, um die Anzeige (118) anzusteuern und von der erzeugten Energie des thermoelektrischen Generators (110) versorgt zu werden.

8. Behälter (100) nach Anspruch 7, bei dem die Verarbeitungseinrichtung (124) einen Datenspeicher zur Speicherung der anzuzeigenden Daten aufweist und / oder ein eingebettetes System oder einen Mikroprozessor umfasst.

9. Behälter (100) nach einem der Ansprüche 1 bis 8, bei dem das Funksystem (128) ausgebildet ist, um die anzuzeigenden Daten über WLAN, GSM, UMTS oder einem Rundfunksystem, wie beispielsweise DVB-T oder DVB-SH zu empfangen.

10. Behälter (100) nach einem der Ansprüche 1 bis 9 mit einem NFC-Modul (132), das ausgebildet ist, um das Funksystem zu konfigurieren, wobei die für die Konfiguration benötigte Energie über das NFC-Modul bereitgestellt wird.

11. Behälter (100) nach einem der Ansprüche 1 bis 10, bei dem die Behälterwand (102) ein thermisch isolierendes Material und/oder eine thermisch isolierende Schicht aufweist.

**Claims**

1. A container for a drink, comprising:

   a thermoelectric generator (110) configured to generate, with a temperature difference between a container inside (106) and a container outside (108), electric energy depending on said temperature difference;
   a display (118) applied on the container inside (106) and/or the container outside (108) and configured to be supplied with energy from the thermoelectric generator (110); and
   a radio system (128) and an antenna (130) for receiving the data to be displayed, wherein the radio system (128) is configured to be supplied with energy from the thermoelectric generator (110);
   wherein the display (118) is configured to display the received data to be displayed;
   wherein the thermoelectric generator (110) is arranged in a region between the container inside (106) and the container outside (108);
   wherein the container wall (102) comprises a thermally conductive material (112) in the region of the thermoelectric generator (110) in order to increase heat transfer between the container inside (106) and the thermoelectric generator (110) and/or the container outside (108) and the thermoelectric generator (110); and
   wherein an energy storage (122), processing means (124), the radio system (128) and/or an NFC module are arranged in the region of the thermally conductive material (112) such that the generated waste heat thereof is, at least partly, used again by the thermoelectric generator (110) to generate energy.

2. The container (100) in accordance with claim 1, wherein the thermoelectric generator (110) is configured to generate the electric energy by means of the Seebeck effect.

3. The container (100) in accordance with claim 1 or 2, wherein the display (118) comprises an electric display or mechanical display or a combination thereof.

4. The container (100) in accordance with claim 1, wherein the display (118) is configured to consume energy only with a change in the data to be displayed, wherein the display (118) includes an electronic paper, a bistable display element, a flap display or a bistable LCD display.

5. The container (100) in accordance with any of claims 1 to 4, comprising an energy storage (122) configured to store the energy generated by the thermoelectric generator (110).

6. The container (100) in accordance with claim 5, wherein the energy storage (122) includes an electronic circuit configured to execute energy management functions.

7. The container (100) in accordance with any of claims 1 to 6, comprising processing means (124) configured to drive the display (118) and be supplied with the energy generated by the thermoelectric generator (110).

8. The container (100) in accordance with claim 7, wherein the processing means (124) comprises a data storage for storing the data to be displayed and/or includes an embedded system or a microprocessor.

9. The container (100) in accordance with any of claims 1 to 8, wherein the radio system (128) is configured to receive the data to be displayed via WLAN, GSM, UMTS or a broadcast system such as, for example, DVB-T or DVB-SH.

**10.** The container (100) in accordance with any of claims 1 to 9, comprising an NFC module (132) configured to configure the radio system, wherein the energy required for configuration is provided via the NFC module.

**11.** The container (100) in accordance with any of claims 1 to 10, wherein the container wall (102) comprises a thermally insulating material and/or a thermally insulating layer.

**Revendications**

**1.** Récipient pour une boisson, aux caractéristiques suivantes:

un générateur thermoélectrique (110) qui est conçu pour générer, à une différence de température entre la surface intérieure du récipient (106) et la surface extérieure du récipient (108), une énergie électrique qui est fonction de la différence de température;
un afficheur (118) qui est placé sur la surface intérieure du récipient (106) et/ou la surface extérieure du récipient (108) et qui est conçu pour être alimenté par l'énergie du générateur thermoélectrique (110); et
un système de radiocommunication (128) et une antenne (130) pour recevoir les données à afficher, le système de radiocommunication (128) étant conçu de manière à être alimenté par l'énergie du générateur thermoélectrique (110);
dans lequel l'afficheur (118) est conçu pour afficher les données à afficher reçues;
dans lequel le générateur thermoélectrique (110) est disposé dans la zone entre la surface intérieure du récipient (106) et la surface extérieure du récipient (108);
dans lequel la paroi de récipient (102) présente, à l'endroit du générateur thermoélectrique (110), un matériau thermo-conducteur (112) pour augmenter le transfert de chaleur entre la surface intérieure du récipient (106) et le générateur thermoélectrique (110) et/ou entre la surface extérieure du récipient (108) et le générateur thermoélectrique (110); et
dans lequel un accumulateur d'énergie (122), un moyen de traitement (124), le système de radiocommunication (128) et/ou un module de NFC à l'endroit de matériau thermo-conducteur (112) sont disposés de sorte que leur chaleur dégagée générée soit, au moins partiellement, à nouveau utilisée par le générateur thermoélectrique (110) pour produire de l'énergie.

**2.** Récipient (100) selon la revendication 1, dans lequel le générateur thermoélectrique (110) est conçu pour générer l'énergie électrique par l'effet Seebeck.

**3.** Récipient (100) selon l'une des revendications 1 à 2, dans lequel l'afficheur (118) comporte un afficheur électrique ou un afficheur mécanique ou une combinaison des deux.

**4.** Récipient (100) selon la revendication 1, dans lequel l'afficheur (118) est conçu pour ne consommer de l'énergie que lors d'un changement des données à afficher, l'afficheur (118) comprenant un papier électronique, un élément d'affichage bistable, un afficheur à palettes ou un afficheur à LCD bistable.

**5.** Récipient (100) selon l'une des revendications 1 à 4, avec un accumulateur d'énergie (122) qui est conçu pour accumuler l'énergie générée du générateur thermoélectrique (110).

**6.** Récipient (100) selon la revendication 5, dans lequel l'accumulateur d'énergie (122) comporte un circuit électronique qui est réalisé pour exécuter des fonctions de gestion d'énergie.

**7.** Récipient (100) selon l'une des revendications 1 à 6, avec un moyen de traitement (124), qui est conçu pour activer l'afficheur (118) et pour être alimenté par l'énergie générée du générateur thermoélectrique (110).

**8.** Récipient (100) selon la revendication 7, dans lequel le moyen de traitement (124) présente une mémoire de données destinée à mémoriser les données à afficher et/ou comporte un système incorporé ou un microprocesseur.

**9.** Récipient (100) selon l'une des revendications 1 à 8, dans lequel le système de radiocommunication (128) est réalisé pour recevoir les données à afficher via WLAN, GSM, UMTS ou un système de radiodiffusiion tel que par exemple DVB-T ou DVB-SH.

**10.** Récipient (100) selon l'une des revendications 1 à 9 avec un module de NFC (132) qui est réalisé pour configurer le système de radiocommunication, l'énergie requise pour la configuration étant mise à disposition par l'intermédiaire du module de NFC.

11. Récipient (100) selon l'une des revendications 1 à 10, dans lequel la paroi de récipient (102) présente un matériau isolant thermique et/ ou une couche isolante thermique.

100

118

102

106            108

104

112

114

120        TEG        110

116

FIG 1

100

118

102

106 108

104

126

124 CPU 112

Energiemanagement
+Energiespeicher

122

114

110

TEG

116

FIG 2

100

118

102

106 108

104 124

126

Funksystem CPU

128

112

Energiemanagement
+Energiespeicher

122

114

110

TEG

116

FIG 3

100

130

118

102

106 → ← 108

104  124

126

128

Funksystem  CPU

112

122  Energiemanagement
+Energiespeicher  NFC

132

TEG

114

110

116

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1972910 A
- JP 1139011 A
- CN 101352307 A